# EUROPÄISCHE PATENTANMELDUNG

(11) **EP 3 933 066 A1**
(43) Veröffentlichungstag der Anmeldung: **05.01.2022**
(21) Anmeldenummer: 20000235.0
(22) Anmeldetag: 30.06.2020
(51) Int. Cl.: C23C 14/00, C23C 14/06, C23C 14/08, C23C 28/00

(54) **SCHUTZSCHICHT GEGEN UMWELTEINFLÜSSE (UMWELTBARRIERESCHICHT) FÜR TI-AL MATERIAL**

(71) Anmelder: Oerlikon Surface Solutions AG, Pfäffikon, 8808 Pfäffikon (CH)
(72) Erfinder: RAMM, Jürgen, 7304 Maienfeld (CH); WIDRIG, Beno, 7310 Bad Ragaz (CH); JARRY, Olivier, 50670 Köln (DE); KOHLHAUSER, Bernhard, 7320 Sargans (CH)

(57) **Zusammenfassung**

Die vorliegende Erfindung bezieht sich auf eine Oberflächenbeschichtung zum Schutz von Substraten mit Ti-Al Material vorzugsweise umfassend eines oder mehrerer der Materialien aus Tabelle 1 wobei die Beschichtung eine Schichtfolge mit mindestens einer Schicht umfasst, die für Ti eine Diffusionsbarriere bildet, vorzugsweise entsprechend einer oder mehrerer der in Tabelle 1 in Zeilen angegebenen Schichtfolgen und wobei die Beschichtung eine auf die Diffusionsbarriere abgestimmte Oxidationsbarriere umfasst die vorzugsweise entsprechend Tabelle 2 abgestimmt ist, wobei die Oberflächenbeschichtung eine thermische Barriere umfasst die vorzugsweise entsprechend Tabelle 3 auf die Oxidationsbarriere abgestimmt ist.

## Beschreibung

Die vorliegende Erfindung betrifft eine Oberflächenbeschichtung zum Schutz von Ti-Al-basierenden Materialien mit hoher mechanischer Festigkeit - wie sie durch das Einbringen intermetallischer Ti-Al Phasen in diese Materialien erzielt werden kann - gegen korrosiven, besonders oxidativen Verschleiss. Die Erfindung betrifft auch ein Schichtsystem, das als thermische Barriereschicht Verwendung finden kann.

Im Rahmen der folgenden Beschreibung werden unterschiedliche Barrieren angesprochen. Dabei soll jeweils Folgendes gemeint sein:
Umweltbarriereschicht:
   Schutzschicht umfassend eine oder meist mehrere Einzelschichten, um eine Substratoberfläche gegenüber schädigenden Einflüssen durch die Umwelt, z. B.
   Oxidation, Korrosion, Verdampfung, Verflüchtigung, Erosion zu schützen.
Diffusionsbarriere :
   Die Diffusionsbarriere hat die Aufgabe, die Diffusion von Elementen zwischen Substrat und einer weiteren Schicht, z.B. einer Oxidationsbarriereschicht, zu verhindern oder lediglich eine begrenzte Diffusion zuzulassen. In der Regel wird die Diffusionsbarriere durch eine Diffusionsbarriereschicht realisiert.
Oxidationsbarriere:
   Die Oxidationsbarriere gemäss der vorliegenden Beschreibung verhindert oder reduziert drastisch die Diffusion des Sauerstoffs zur Diffusionsbarriereschicht oder zum Interface zwischen Diffusionsbarriereschicht und Substratoberfläche. In der Regel wird die Oxidationsbarriere durch eine Oxidationsbarriereschicht realisiert.
Thermische Barriere:
   Die thermische Barriere hat die Aufgabe das Substratmaterial vor zu hoher Temperatur zu schützen und damit für Temperaturbereiche einsetzbar zu machen, die oberhalb dessen Einsatztemperatur bezüglich der mechanischen Festigkeit liegen. Als Schicht (thermische Barriereschicht) wird sie mit genügend grosser Dicke und/oder genügend kleiner Wärmeleitfähigkeit so ausgestaltet, dass über deren Dicke ein gewünschter Temperaturabfall erzielt wird

### Hintergrund der Erfindung

Ti-Al-basierende Materialien sind wegen ihrer geringen Dichte und hohen Festigkeit bevorzugte und wünschenswerte Materialien für Bauteile in Flugzeugturbinen. Deshalb werden gegenwärtig Ti-Al-basierende Materialien auf ihre Eignung hin untersucht, um Ni-basierende Superlegierungen vor allem im Flugzeugbereich zu ersetzen [B.P. Bewlay et al., Materials at High Temperatures 33 (2016) 549; N.P. Padture, Nature Materials 15 (2016) 804]. Darüber hinaus finden diese Materialien auch Anwendungen in anderen Bereichen, so beispielsweise für Anwendungen in der Hochleistungsautomobiltechnik [T.Tetsui and Y. Miura, Mitsubishi Heavy Industries, Ltd., Technical Review 39 (2002) 1] und in der Nuklearindustrie [H. Zhu et al., The Journal of The Minerals, Metals & Materials Society 64 (2012) 1418]. Allerdings haben diese Materialien den Nachteil, dass sie bei hohen Temperaturen nicht oxidationsbeständig sind und Diffusionsprozessen unterliegen, die ihre mechanischen Eigenschaften verschlechtern.

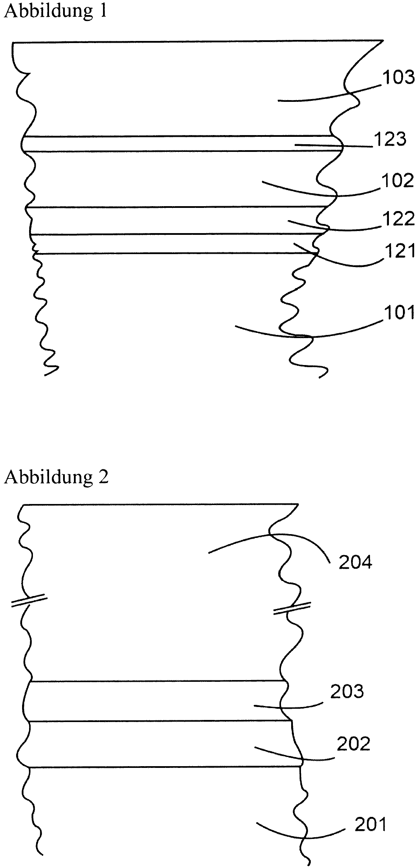

Im Zusammenhang mit Turbinenanwendungen werden insbesondere Ti-Al basierende Materialien untersucht, die die intermetallischen Phasen γ-TiAl und α2-Ti3Al enthalten und die zusätzliche Dotierungen mit anderen Elementen enthalten können wie sie beispielsweise von N. R. Muktinutalapati, Materials for Gas Turbines - An Overview, Advances in Gas Turbine Technology, Dr. Ernesto Benini (Ed.), (2011) (ISBN: 978-953-307-611-9) in Tabelle 13 auf Seite 308 beschrieben sind. Wie schon erwähnt, müssen die Oberflächen dieser Materialien gegen Oxidation geschützt werden und es müssen die Diffusionsprozesse, die bei erhöhten Temperaturen sowohl im Substratmaterial wie im Bereich zwischen Substratmaterial und Oxidationsschutzschicht auftreten unterbunden oder in einem gewünschten Masse kontrolliert werden. Im allgemeinen wird deshalb eine Schutzbeschichtung aus einer Diffusionsbarriereschicht und einer Oxidationsbarriereschicht (Abbildung1) angestrebt. Zudem wird die Möglichkeit untersucht, ob eine zusätzliche thermischen Barriereschicht, die auf der Oxidationsbarriereschicht aufgebracht ist, die Anwendung solcher Materialien zu noch höheren Einsatztemperaturen erweitern kann. Für die Ni-basierenden Superlegierungen wird eine solche thermische Barriereschicht bekanntermassen dadurch realisiert, dass man als erste Schicht auf der Superlegierung eine sogenannte MCrAlY Schicht als Interface (Zwischenschicht) aufbringt, die zwar von ähnlicher fcc (face-centred cubic) Struktur ist wie die Superlegierung, aber etwas höheren Al-Gehalt aufweist als das Superlegierungssubstrat, und die beim Aufheizen in Umgebungsatmosphäre oberhalb von etwa 1000°C eine dichte dünne Aluminiumoxidschicht, das sog. Oxidscaling, an ihrer Oberfläche bildet. Kombinieren lässt sich diese MCrAlY Schicht mit einer dicken (200 µm bis 1000 µm) und zudem porösen YSZ (Yttria-stabilized Zirconia) Schicht, über der ein Temperaturabfall von bis zu 150°C realisiert werden kann und damit eine höhere Einsatztemperatur für die Superlegierungssubstrate ermöglicht wird. Dieser Ansatz wäre selbstverständlich auch vorteilhaft für die Ti-Al-basierenden Substrate, ist aber schwierig umzusetzen, da ein Aufheizen auf die notwendigen 1000°C die Festigkeit des Substratmaterials bereits reduzieren würde bevor sich eine Schutzschicht bilden kann.

Eine wichtige Voraussetzung, um die Oxidationsbeständigkeit des Ti-Al-Materials durch eine Beschichtung der Oberfläche zu erhöhen, ist die Stabilität des Interfaces zwischen der Beschichtung und dem Ti-Al Substratmaterial. Einige Gründe dafür werden im Folgenden diskutiert. Schon während der Beschichtung kann der erhöhte Energieeintrag an der Substratoberfläche zu Diffusionsvorgängen im oberflächennahen Bereich der zu beschichtenden Substrate und in den ersten Schichtlagen führen. Solche Diffusionsvorgänge hängen sowohl von der Art des zur Beschichtung verwendeten Metalldampfes ab, als auch von den dem Beschichtungsprozess beigefügten Prozessgasen. Beispielsweise kommt es zur Stickstoffdiffusion in das Substrat, falls etwa Schichten aus TiN oder TiAlN aufgebracht werden sollen, also die Schichtsynthese mit Hilfe eines Stickstoffplasmas erfolgt. Diese Stickstoffdiffusion führt zu einer Schwächung der mechanischen Eigenschaften im oberflächennahen Bereich des zu beschichtenden Substrates. Noch drastischer ist der Schwächungseffekt, falls die Ti-Al-Substratoberfläche mit Sauerstoff während der Beschichtung in Verbindung kommt. Das Resultat ist die Bildung von Ti-O-Verbindungen, die schlechte mechanische Eigenschaften aufweisen. Gleichzeitig mit solchen Oxidationsvorgängen kommt es zu beschleunigten Diffusionsprozessen, die eine Instabilität des Interfaces fördern, was sich meist in einer Lochbildung (void formation) äussert.

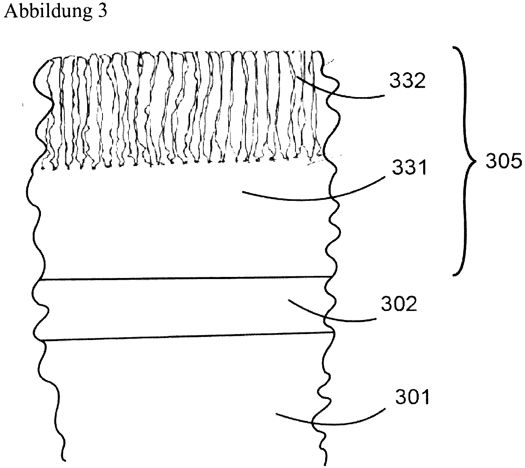

Wie bei den Superlegierungen, besteht auch für die Ti-Al-Materialien der Wunsch, deren Nutzungsbereich nach höheren Temperaturen hin auszudehnen. Das kann über das Aufbringen einer thermischen Barriereschicht erfolgen, über die ein Temperaturabfall realisiert werden kann. Dabei kann die thermische Barriereschicht ein zusätzliches Schichtsystem sein, das auf dem Schichtsystem von Abbildung1 aufgebracht wird (in Abbildung 2 gezeigt). Es kann aber auch ein vereinfachter Ansatz verfolgt werden, indem nämlich die Schichten, die für die Umweltbarriereschicht (Environmental Barrier Coating (EBC)) in Abbildung1 beschrieben sind, erweitert werden um eine thermische Barriereschicht, etwa indem die Oxidationsbarriere nur wesentlich dicker ausgebildet ist (in Abbildung 3 gezeigt). Besonders geeignet für eine thermische Barriereschicht sind Schichtmaterialien, mit denen ein besonders grosser Temperaturabfall realisiert werden kann, d.h. Materialien mit kleiner Wärmeleitfähigkeit, aber mit guter mechanischer Stabilität bei hohen Temperaturen. Bei den hier zu schützenden Ti-Al-Materialien kann man bereits Temperaturen über 900°C als hohe Temperaturen betrachten, weil diese eine wesentliche Erweiterung des Anwendungsbereiches dieser Ti-Al-Materialien zulassen würden (N. R. Muktinutalapati, Materials for Gas Turbines - An Overview, Advances in Gas Turbine Technology, Dr. Ernesto Benini (Ed.), (2011) (ISBN: 978-953-307-611-9) in Tabelle 13 auf Seite 308). Mit anderen Worten, die thermische Barriereschicht muss nicht unbedingt auf einem YSZ Material basieren, das bis ca. 2000°C thermisch stabil ist, sondern es könnte auch ein Material sein, das bis etwa 1500°C thermische Stabilität aufweist oder sogar unterhalb dieser Temperatur. Neben der wünschenswerten kleinen Wärmeleitfähigkeit solcher Materialien ist es vor allem wichtig, dass sich durch den Beschichtungsprozess eine Schichtmorphologie herstellen lässt, die durch grosse Porosität gekennzeichnet ist , aber trotzdem mechanisch stabil ist.

### Lösung

Eine erste Lösung für dieses Problem ist ein Schichtsystem nach Abbildung 1, dessen Interface zwischen Schicht und Substrat entweder eine Diffusion verhindert oder sich durch (limitierte) Diffusionsvorgänge stabilisiert, d.h. keine (oder nur eine unwesentliche Anzahl) Fehlstellen (voids) bildet.

Zusätzlich weist das erfindungsgemässe Schichtsystem nach Abbildung 1 an seiner Oberfläche eine stabile Oxidationsbarriere auf oder es bildet eine solche stabile Oxidationsbarriere während des Betriebs, damit kein Sauerstoff zum Substrat-Schicht Interface gelangen kann.

Diese beiden Anforderungen sind notwendige Voraussetzungen für ein Schichtsystem, das die Stabilität der Oberfläche von Ti-Al-Substratmaterialien für einen vorgegebenen Temperaturbereich garantiert. Dieser Temperaturbereich wird einerseits durch die spezifische Anwendung vorgegeben, andererseits durch die mechanische Festigkeit des Ti-Al-Grundmaterials, die u.a. von der chemische Zusammensetzung, Kristallstruktur und Kristallitgrösse abhängt.

Ein weiterer Aspekt des erfindungsgemässen Schichtsystems besteht darin, dass in den erfindungsgemässen Varianten die Umweltbarriereschicht von Abbildung 1, wie in Abbildung 2 gezeigt, um eine thermische Barriereschicht erweitert wird.

### Beschreibung der Abbildungen

Abbildung 1 zeigt schematisch ein erfindungsgemässes Schichtsystem einer Umweltbarriereschicht für Ti-AI-Material. Die Abbildung umfasst das Ti-Al-Substratmaterial 101, das beispielsweise ein Material sein kann, das in N. R. Muktinutalapati, Materials for Gas Turbines - An Overview, Advances in Gas Turbine Technology, Dr. Ernesto Benini (Ed.), (2011) (ISBN: 978-953-307-611-9) in Tabelle 13 auf Seite 308 beschrieben ist. Aber es kann auch Modifikationen in der chemischen Zusammensetzung aufweisen. Auf diesem Substratmaterial wird im Rahmend der Erfindung die erste Schicht 102 abgeschieden, die bezüglich ihrer Funktion eine Diffusionsbarriere ist für den Temperaturbereich des spezifischen Einsatzes des Materials. Diese Diffusionsbarriere garantiert zugleich die Schichthaftung des gesamten Schichtsystems auf dem Substratmaterial. Die Schicht hat die Aufgabe, die Diffusion zwischen Substrat und der Folgeschicht zu verhindern öder lediglich eine begrenzte Diffusion zuzulassen, die zu einer Verbesserung der Haftung auf dem Substrat führt, aber durch die zur Verfügung stehenden Materialmenge (dünne Schicht) sich selbst begrenzt. Zur Haftungsverbesserung auf den unterschiedlichen Substratmaterialien und für die verschiedenen Anwendungsbereiche der Schichtsysteme kann eine dünne metallische Schicht 121 vorteilhaft verwendet werden. Zudem kann es hilfreich sein, einen Gradienten 122 in der chemischen Zusammensetzung der Metall-Siliziumschicht zu erzeugen, ehe die in ihrer chemischen Zusammensetzung gewünschte Metall-Siliziumschicht-Zusammensetzung als eigentliche Diffusionsbarriere (102) beschichtet wird. Die zweite Schicht des Schichtsystems 103 unterbindet die Diffusion des Sauerstoffs (Oxidationsbarriere) zur Diffusionsbarriere oder zum Interface zwischen Diffusionsbarriere und Substratoberfläche. Je nach Schichtmaterial kann es vorteilhaft sein, dass vor dem Abscheiden der Oxidationsbarriere in einer Sauerstoffumgebung ein schützendes Oxidscaling 123 auf der Me-Si Diffusionsbarriere erzeugt wird, damit die Diffusion von aktiviertem Sauerstoff aus dem Sauerstoffplasma, das bei der Synthese der oxidischen Oxidationsbarriere benötigt wird, unterbunden wird.

Wesentliche Merkmale für eine wirksame Umweltbarriereschicht sind die Verhinderung einer Ti-Diffusion an die Oberfläche des Schichtsystems nach dem Ausheizprozess an Atmosphäre und der Nachweis guter Haftung zwischen Schichtsystem und Substrat nach dem Annealing in Umgebungsatmosphäre.

### Abbildungen:

### Abbildung 1

Erfindungsgemässes Schichtsystem für eine EBC auf einem Ti-Al- Substrat, bestehend aus Substrat 101, Diffusionsbarriere 102 und Oxidationsbarriere 103.

In der Abbildung 1 bedeuten:
101 Ti-Al-basierendes Substrat, das gegen Oxidation geschützt werden soll.
102 Diffusionsbarriereschicht, die als Zwischenschicht (Interface) zwischen Ti-Al-basierendem Substrat und der Oxidationsbarriereschicht angebracht ist.
121 metallische Haftschicht
122 Gradientenschicht in dem Metall-Silizium Schichtmaterial
123 Oxidscaling
103 Oxidationsbarriereschicht, die das Schichtsystem an dessen Oberfläche zur Umwelt hin gegenüber oxidativen Vorgängen abschliesst.

### Abbildung 2

Erfindungsgemässes Schichtsystem für eine EBC auf einem Ti-Al- Substrat, bestehend aus Substrat 201, Diffusionsbarriere 202, Oxidationsbarriere 203 und einer weiteren thermischen Barriereschicht 204.

D.h. Abbildung 2 zeigt die Erweiterung der Oxidationsbarriereschicht 203 um eine weitere Schicht 204, die die Funktion einer thermischen Barriereschicht aufweist. Im allgemeinen ist eine solche thermische Barriereschicht thermisch stabil in dem vorgegeben Temperaturbereich und weist bevorzugt niedrige Wärmeleitung auf, die durch das Schichtmaterial - beispielsweise durch ein Oxid - gegeben ist oder durch eine erhöhte Porosität der Schicht erreicht wird.

In der Abbildung 2 bedeuten:
201 Ti-Al-basierendes Substrat, das gegen Oxidation geschützt werden soll.
202 Diffusionsbarriereschicht, die als Zwischenschicht (Interface) zwischen Ti-Al-basierendem Substrat und der Oxidationsbarriereschicht angebracht ist.
203 Oxidationsbarriereschicht, die das Schichtsystem an dessen Oberfläche zur Umwelt hin gegenüber oxidativen Vorgängen abschliesst.
204 Thermische Barriereschicht

### Abbildung 3

Erfindungsgemässes Schichtsystem für eine EBC auf einem Ti-Al- Substrat, bestehend aus Substrat 301, Diffusionsbarriere 302, Oxidationsbarriere 305 aus 331 und 332, welche zu grösserer Schichtdicke hin erweitert wurde und die mit zunehmender Schichtdicke poröser werdenden Schichtmorphologie in 332 aufweist.

In Abbildung 3 ist dementsprechend ein weiteres Schichtsystem dargestellt, das gegenüber dem Schichtsystem von Abbildung 2 einen vereinfachten Schichtaufbau zeigt. In diesem Schichtsystem sind die Oxidationsbarriereschicht 203 und die thermische Barriereschicht 204 aus Abbildung 2 in einer Schicht 305 zusammengefasst, die beide Funktionen erfüllt. Man kann dies durch einen Gradienten in der Schichtmorphologie realisieren, also etwa indem die Schicht 305 in der Nähe des Interfaces 331 dichter gemacht wird, um eine gute Haftung zu erzielen, dann aber mit zunehmender Schichtdicke stufenweise und oder kontinuierlich in eine säulenartige oder andersgeartete poröse Struktur 332 übergeht wie es in der Abbildung 3 angedeutet ist.

In der Abbildung 3 bedeuten:
301 Ti-Al-basierendes Substrat, das gegen Oxidation geschützt werden soll.
302 Diffusionsbarriereschicht, die als Zwischenschicht (Interface) zwischen Ti-Al-basierendem Substrat und der Oxidationsbarriereschicht angebracht ist.
305 Kombination von Oxidationsbarriereschicht und thermischer Barriereschicht beruht im wesentlich auf dem gleichen Materialsystem (dem der Oxidationsbarriere), aber ausgehend von dichter Morphologie der Schicht 231 aus Abbildung 2 im Interface zur Diffusionsbarriere und danach wechselnd zu zunehmend poröser Morphologie wie Schicht 332 aus Abbildung 3 mit zunehmender Schichtdicke.

### Abbildung 4

XRD Spektrum einer erfindungsgemässen Mo-Si Diffusionsbarriereschicht, die mit einem Silanfluss von 90 sccm hergestellt wurde und das die Koexistenz von Mo und MoSi2 Phasen in der Schicht nachweist.

### Abbildung 5

XRD Spektrum einer erfindungsgemässen Mo-Si Diffusionsbarriereschicht, die mit einem Silanfluss von 180 sccm hergestellt wurde und die hauptsächlich die MoSi2 Phase aufweist.

### Abbildung 6

REM Schichtquerschnitt einer Umweltbarriereschicht bestehend aus einer 4.9 µm dicken Mo-Si Schicht (Diffusionsbarriere) und einer 2.7 µm dicken Al-Cr-O Schicht (Oxidationsbarriere).

### Abbildung 7

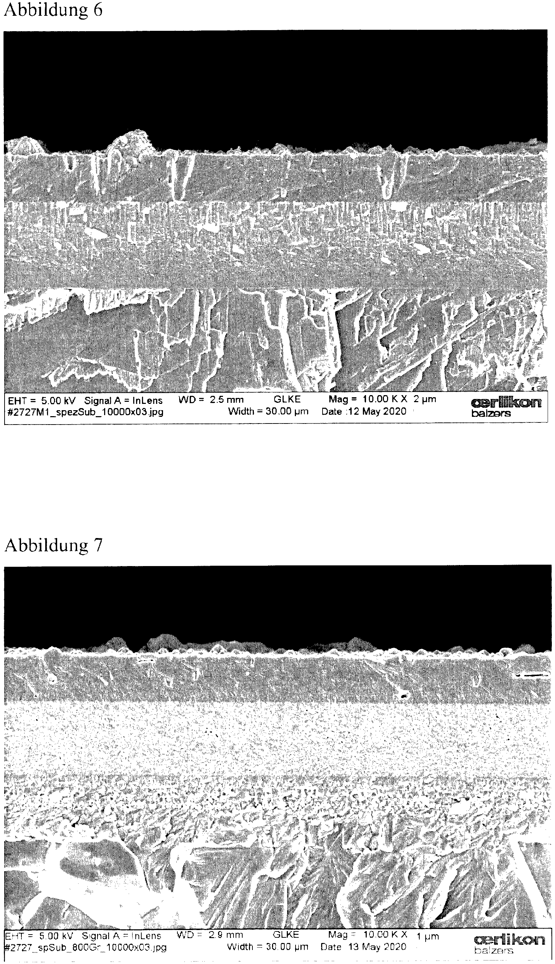

REM Schichtquerschnitt der Umweltbarriereschicht aus Abbildung 6 nach einem Annealing an Atmosphäre bei 800°C für eine Dauer von 20 h. Die Al-Cr-O Schicht (Oxidationsbarriere) zeigt nach dem Annealing keine Veränderung in Dicke oder Morphologie. Im Interface zum Substrat erfolgt eine limitierte Diffusion über einen Bereich eingeschlossen der Diffusionsbarriere von insgesamt ca. 8 µm, die zu keiner Lochformierung führt.

### Abbildung 8

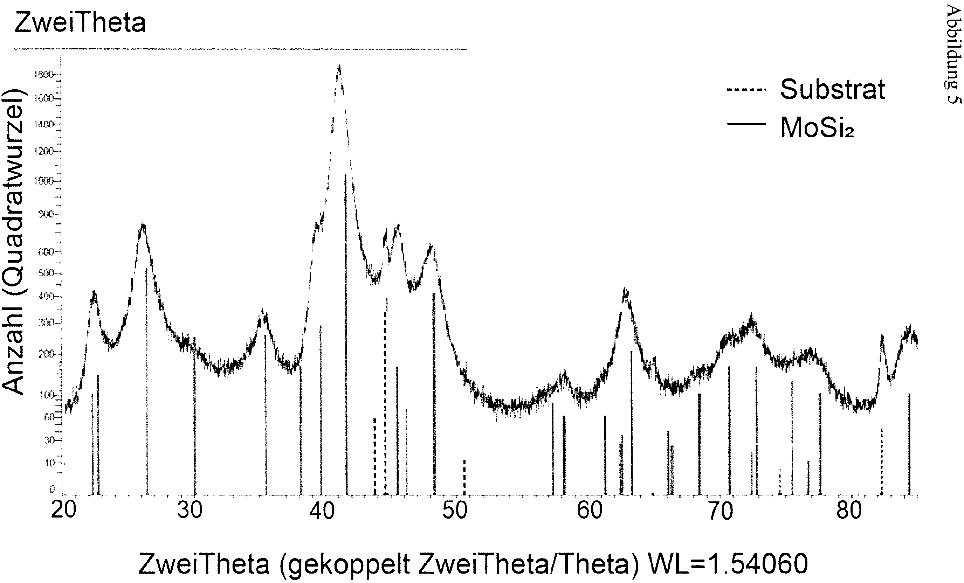

REM Schichtquerschnitt einer Mo-Si Diffusionsbarriere, bei der auf die Oxidationsbarriere verzichtet wurde. Diese vereinfachte Variante zeigte unmittelbar nach der Beschichtung, die wieder bei 450°C durchgeführt wurde, im REM Schichtquerschnitt keine Anzeichen von Diffusionsvorgängen im Interface. Die Schicht wurde mit einem Silanfluss von 180 sccm hergestellt und ist charakterisiert durch das XRD Spektrum, das in Abbildung 5 gezeigt ist.

### Abbildung 9

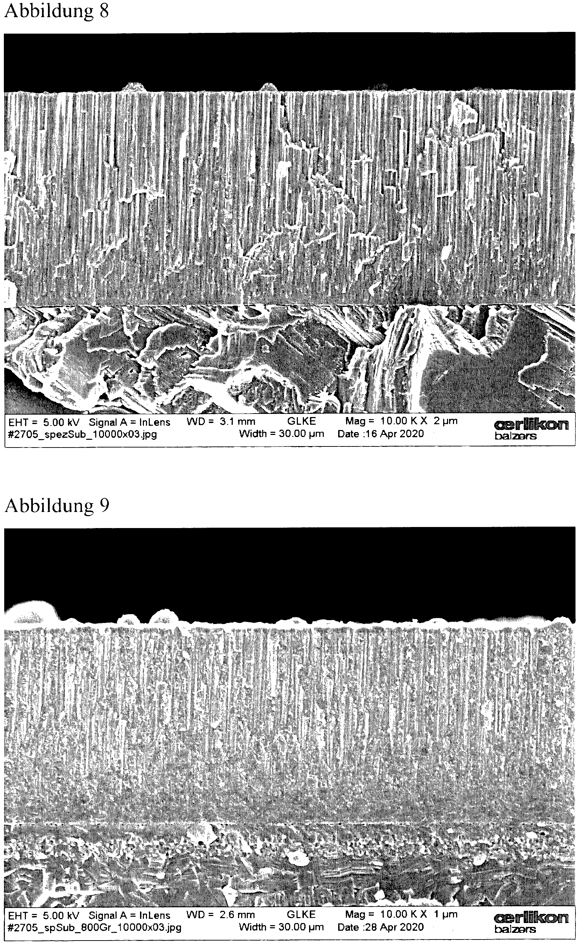

REM Schichtquerschnitt der Mo-Si Diffusionsbarriere aus Abbildung 8 nach dem Annealing an Atmosphäre bei 800°C für eine Dauer von 20 h. Es kommt zu einem Diffusionsprozess in der Interfaceregion im Bereich von ca. 2 µm. Zusätzlich diffundiert Al zur Schichtoberfläche und bildet ein Al-O Scaling.

### Abbildung 10

REM Schichtquerschnitt der Mo-Si Diffusionsbarriere aus Abbildung 9, aber mit der zehnfachen Vergrösserung. Dadurch wird das etwa 200 nm dicke Al-O Scaling deutlicher sichtbar

### Prozess zur Herstellung der Schichtsysteme

Der Beschichtungsprozess kann als eine Kombination aus Physical Vapour Deposition (PVD) und Plasma unterstützter Chemical Vapour Deposition (PECVD) ausgeführt werden, d.h. es werden beide Methoden gegebenenfalls insbesondere gleichzeitig benutzt, um die Schichtsynthese zu realisieren. Als PVD Methoden können beispielsweise Elektronenstrahlverdampfung, Sputtern und/oder kathodische Funkenverdampfung benutzt werden. Die CVD Methoden basieren im Wesentlichen auf zusätzlichen Gaseinlässen mit denen in das benutzte Beschichtungssystem die verschiedenen gasförmigen Precursor eingelassen werden können, welche dann im Plasma zerlegt und angeregt werden. Vorteilhafterweise wird dasselbe Beschichtungssystem für die PVD Methoden und für die CVD Methoden verwendet. Das für die CVD Methoden benötigte Plasma kann mittels der aufgrund der PVD Methode vorhandenen Plasmaquelle generiert werden, also beispielsweise durch die kathodische Funkenquelle. Es kann aber auch auf andere Weise, beispielsweise durch eine separate Niedervoltbogenentladung erzeugt werden. Diese Methoden sind dem Fachmann auf diesem technologischen Gebiet bekannt.

Im Folgenden wird ein Beispiel angegeben, das die Herstellung eines erfindungsgemässen Schichtsystems erläutert und beschreibt, ohne dass diese Beschreibung des beispielhaften Schichtsystems die allgemeinere Erfindungsidee einschränken soll.

Als erstes wird der Ablauf bei der Herstellung des erfindungsgemässen Schichtsystems nach Abbildung 1 beschrieben.

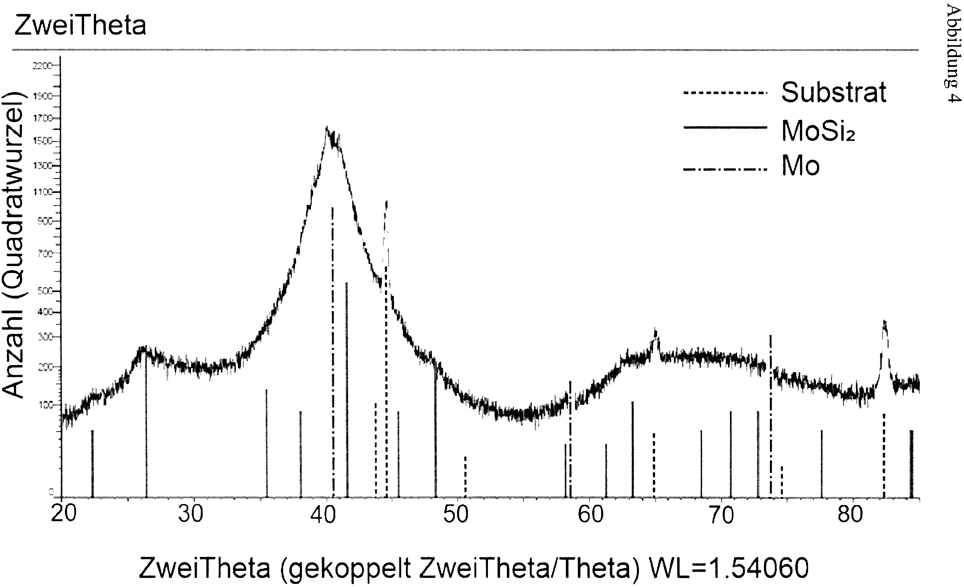

Die TiAl Substrate werden in das Beschichtungssystem eingebracht und auf den entsprechenden Halterungen fixiert. Die Halterungen sind auf einem Substrathalterungssystem montiert, das während der Beschichtung steht und/oder ein-, zwei- und/oder dreifach rotiert werden kann. Das Beschichtungssystem wird abgepumpt auf einen Druck von etwa 10⁻⁵ mbar oder kleiner. Dann erfolgt die Vorbehandlung der Substrate. Dabei werden diese auf eine gewünschte Temperatur (200°C bis 600°C) im Beispiel mittels Strahlungsheizern aufgeheizt und es wird eine Substratvorbehandlung in der Anlage durchgeführt, beispielsweise eine Reinigung der Substratoberfläche durch Sputtern mit Ar Gasionen. Für den Reinigungsschritt wird üblicherweise eine negative Spannung (Substratbias) an die Substrate gelegt. Nach diesen Vorbehandlungsschritten wird im Beispiel dieser negative Substratbias auf einen Wert eingestellt, beispielsweise -40 V, der während der Beschichtung eingehalten wird. Als Beispiel wird hier die Synthese einer Mo-Si Schicht in einer Kombination von PVD und CVD Prozess für die Diffusionsbarriereschicht beschrieben. Die Beschichtung beginnt mit der Zündung der kathodischen Funkenentladung auf dem Mo Target, das als Kathode der Funkenentladung geschaltet ist und demzufolge durch den kathodischen Funken verdampft wird. Gleichzeitig oder, wie für das Beispiel unten beschrieben, gegeneinander kurzzeitig versetzt wird das Reaktivgas eingelassen. Unterstützend kann auch noch ein Edelgas oder eine Edelgasmischung eingelassen werden. Die Funkenentladung wird im Beispiel mit einem Quellenstrom von 220 A betrieben. Mit einem zeitlichen Versatz von 2 min wird ein Silanfluss von 90 sccm beigegeben. An den Substraten wird eine Biasspannung von -40 V angelegt. Auf diese Weise kommt es zu einer Beschichtung der Substrate mit einer Mo-Si Schicht, wobei die chemische Zusammensetzung dieser Schicht in weiten Bereichen über die Verdampfungsrate des Mo Targets (Funkenstrom) und über den Silanfluss regelbar ist und demzufolge die chemische Zusammensetzung der Schicht eingestellt werden kann. Als Beispiel ist in Abbildung 4 ein Röntgendiffraktogramm (XRD Spektrum) einer solchen Mo-Si Schicht gezeigt. Die charakteristischen Bragg Peaks dieses Spektrums belegen, dass unter den oben angegeben Beschichtungsparametern eine Schicht synthetisiert wird, die im Wesentlichen aus Mo und MoSi2 besteht. Das Abstimmen der Mo Beschichtungsrate mit dem Silanfluss erlaubt eine quasi freie Wahl der existierenden Mo-Si Verbindungen, so wie diese im Mo-Si Phasendiagram beschrieben sind. In Abbildung 5 ist das XRD Spektrum einer Mo-Si Schicht dargestellt, die mit 180 sccm Silanfluss (anstatt 90 sccm wie in Abbildung 4) hergestellt wurde. In diesem Spektrum sind im Wesentlichen nur die Bragg Peaks für das MoSi2, das in einer Mischung von zwei Kristallstrukturen synthetisiert wurde, zu erkennen, d.h. der höhere Silanfluss verschiebt die chemische Zusammensetzung der synthetisierten Schicht zu den chemischen Verbindungen mit dem höheren Si-Gehalt. Für bestimmte Anwendungen kann diese Schicht allein als Umweltbarriereschicht verwendet werden, nämlich dann wenn an ihrer Oberfläche ein Oxidscaling erzeugt wird. Das wird ausführlicher weiter unten anhand der Abbildungen 8 bis 10 diskutiert.

Der folgende Prozessschritt, nämlich die Abscheidung der Oxidationsbarriere, erfolgt ohne Unterbrechung des Vakuums im Anschluss an die Abscheidung der Mo-Si Schicht. Der Uebergang zwischen der Abscheidung der Diffusionsbarriere und der Oxidationsbarriere kann sowohl abrupt gestaltet werden, also ausschalten der Funkenentladung auf dem Mo Target und Ausschalten des Silanflusses und danach Start des Beschichtungsprozesses für die Oxidationsbarriere. Es kann aber auch ein Prozessübergang in der Beschichtung zur Oxidationsbarriere, in diesem Beispiel ist das eine Al-Cr-O Schicht, gewählt werden, der fliessend gestaltet wird und der hier beschrieben werden soll. Dafür wird die kathodische Funkenentladung auf einem Al-Cr Target, bevorzugt mit einer Targetzusammensetzung von Al(70at.%)-Cr(30at%), in den letzten 3 Minuten des Beschichtungsprozesses für die Diffusionsbarriere, also noch während dieses Prozessschritts gezündet (Funkenstrom 180A). Nach Verlauf weniger Minuten wird zusätzlich dasjenige Flowmeter auf Gaseinlass eingestellt, das einen Sauerstofffluss von 400 sccm dem Beschichtungssystem zuführt. Nach Stabilisierung des Sauerstoffflusses (ca. 1 Minute) werden das Mo Target ausgeschaltet und das Silanflowmeter auf Verschluss des Silangaseinlasses eingestellt, d.h. der Silanfluss ausgeschaltet. Resultat ist die Formierung einer Al-Cr-O Schicht auf und leicht überlappend mit der Mo-Si Diffusionsbarriere.

Falls ein erfindungsgemässes Schichtsystem nach Abbildung 2 oder 3 hergestellt werden soll erfolgt dann als nächster Schritt im Prozessablauf entweder eine Weiterführung der Oxidationsbarriereschicht zu grösseren Dicken hin (entsprechend Abbildung 3) und mit entsprechend höherer Porosität (beispielsweise durch Vergrösserung des Sauerstoffgasflusses) oder eine Schichtabscheidung (entsprechend Abbildung 2) unter Benutzung der entsprechenden Targets, wie etwa solche aus Zr-Y, um eine YSZ Schicht wie in Tabelle 3 beschrieben.

### Beispiele der erfindungsgemäss hergestellten Schichten

Ein Schichtsystem umfassend und/oder bestehend aus einer Mo-Si Diffusionsbarriere und einer Oxidationsbarriere ist als Beispiel in Abbildung 6 dargestellt, die einen Schichtquerschnitt aufgenommen im Rasterelektronenmikroskop (REM) zeigt, der dem erfindungsgemässen Schichtsystem von Abbildung 1 entspricht. Das Schichtsystem besteht aus einer 4.9 µm dicken Mo-Si Schicht (Diffusionsbarriere) und einer 2.7 µm dicken Al-Cr-O Schicht (Oxidationsbarriere). Die Abbildung 6 illustriert einen Schichtaufbau, der die Bedingungen erfüllt, die weiter oben an eine Umweltbarriereschicht für das Ti-Al Substratmaterial gestellt wurden. Die Diffusionsbarriere unterbindet die Diffusion von Ti in die aufgebrachte Schicht und die Diffusion von Elementen der aufgebrachten Schicht in das Substratmaterial. Nach der Prozessbeschreibung besteht bei diesem Verfahren auch die Möglichkeit, über die Anpassung der Beschichtungsraten im Interface zum Substrat hin eine in ihrer Zusammensetzung gradierte Me-Si Schicht zu erzeugen, die sich vorteilhaft auf die Schichthaftung auswirkt. In diesem Zusammenhang sei noch erwähnt, dass zusätzlich und vor der Me-Si Schicht eine andere metallische Schicht als Haftschicht auf das Substrat aufgebracht werden kann für eine weitere Verbesserung der Haftung des Schichtsystems. Beispielsweise kann dies das Metall aus der Me-Si Schicht sein, oder es kann ein Haftschichtmetall verwendet werden und ein Gradient zu einer Me-Schicht und oder einer Me-Si Schicht erstellt werden.

Auch die zweite Anforderung an eine Umweltbarriereschicht wird mit einem solchen Schichtsystem erfüllt. Die Al-Cr-O Schicht verhindert das Eindringen des Sauerstoffs und damit dessen Diffusion zum Interface zwischen Substrat und Schichtsystem.

Die notwendigen Bedingungen, die formuliert wurden, um eine Umweltbarriereschicht auf Ti-Al Substraten zu realisieren werden durch das obige Beispiel erfüllt. Si unterbindet die Diffusion im Interface zum Substratmaterial bei der Beschichtung. Das trifft auf eine reine Si Schicht zu, aber auch auf Me-Si Schichten, die eine bessere Haftung auf dem Ti-Al Substrat garantieren und mechanisch wesentlich stabiler sind als eine reine keramikartige Si Schicht. In Abbildung 7 ist der REM Schichtquerschnitt des Schichtsystem von Abbildung 6, das bei einer Substrattemperatur von 450°C abgeschieden wurde, nach einem Ausheiztest von 20 h bei 800°C in Umgebungsatmosphäre dargestellt. Der Vergleich der beiden Schichtsysteme zeigt einmal die exzellente Stabilität der Al-Cr-O Oxidationsbarriere, bei der keine Veränderungen sichtbar sind und die stabil bleibt. Die Mo-Si Diffusionsbarriere hingegen erlebt einen Diffusionsprozess im Interface zum Ti-Al Substrat, der jedoch nicht zu Lochbildung und zu einer Destabilisierung des Interfaces führt.

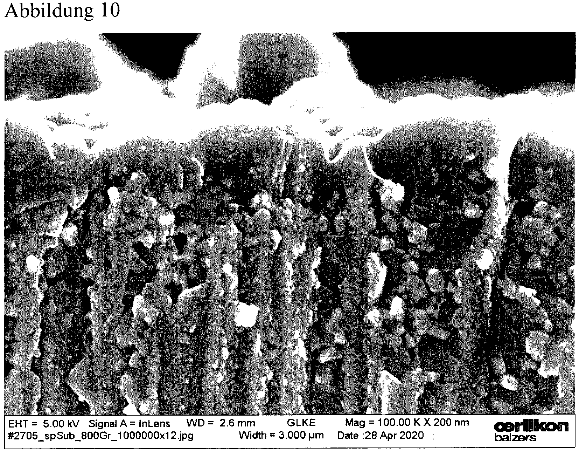

Es wurde auch eine vereinfachte Variante der in Abbildung 1 beschriebenen Umweltbarriereschicht untersucht. Diese bestand darin, dass die Beschichtung des Ti-Al Substrats nach der Ablegung der Mo-Si Diffusionsbarriere beendet wurde, also auf die Abscheidung der Oxidationsbarriere verzichtet wurde. Diese vereinfachte Variante zeigte unmittelbar nach der Beschichtung, die wieder bei 450°C durchgeführt wurde, sowohl im REM Querschnitt als auch im Linienscan keine Anzeichen von Diffusionsvorgängen im Interface (Abbildung 8) und einen sehr abrupten Uebergang in der Schichtmorphologie zwischen Substrat und Mo-Si Diffusionsbarriere. Das beschichtete Ti-Al Substrat wurde danach für 20 h bei 800°C in Umgebungsatmosphäre ausgeheizt. Dabei zeigte es sich (das wurde mittels EDX Messungen über den Schichtquerschnitt ermittelt), dass es im Interface zur Diffusion in einem begrenzten Bereich kam, als deren Resultat eine Anreicherung des Al unmittelbar zum Substrat hin erfolgte und sich daran anschliessend ein Bereich von Ti-Si bildete bevor der Uebergang zum Mo-Si erfolgte. Auch in diesem Falle führten die Diffusions- oder Umordnungsprozesse im Interface zum Substrat zu keiner Lochbildung, sondern die Schicht blieb auch nach dem Ausheizen stabil wie es der REM Schichtquerschnitt in Abbildung 9 zeigt. Wichtig ist aber vor allem, dass die Umordnung im Interface zu einer zusätzlichen Diffusion des Al an die Schichtoberfläche führte und sich als Folge dieser Diffusion und des Ausheizprozesses ein Oxidscaling (Abbildung 10) an der Mo-Si Schichtoberfläche bildete. Dieses Oxidscaling ist für viele Anwendungen als Schutzschicht ausreichend. Zudem ist es auch vorteilhaft, falls ein Schichtsystem wie in Abbildung 2 oder 3 angestrebt wird und die Umweltbarriereschicht aus Abbildung 1mit einer thermischen Barriereschicht beschichtet wird, die nicht, wie zum Beispiel das Al-Cr-O, sehr gute Eigenschaften als Oxidationsbarriere aufweist, sondern geringe Sauerstoffdiffusion zulässt (wie es im Falle von YSZ wäre). Der oben beschriebene Vorgang der Diffusion des Al zur Silizidoberfläche bildet somit eine Al-O Barriereschicht und stoppt eine eventuelle Sauerstoffdiffusion durch die thermische Barriereschicht an der Al-O Barriereschicht, die als Oxidationsbarriere wirkt.

Dieser Vorgang des Oxidscalings ist auch noch in einem anderen Zusammenhang bedeutsam und zwar dann, falls der Uebergang von der Me-Si Diffusionsbarrierezur Oxidationsbarriereschicht problematisch ist in dem Sinn, dass die Benutzung eines Sauerstoffplasmas zur Abscheidung der oxidischen Oxidationsbarriereschicht die Diffusionsbarriereschicht angreift. In einem solchen Falle ist es möglich, dass ein Al-O Scaling ohne Unterbruch des Vakuums erzielt wird, indem die Oberfläche der Me-Si Diffusionsbarriereschicht bei erhöhter Temperatur nicht-plasmaktiviertem Sauerstoff ausgesetzt wird.

Die Erfinder haben eine Reihe von Schichtmaterialien im Hinblick auf die Diffusionsbarriereeigenschaften für Ti-Al Material getestet und herausgefunden, dass Me-Si Schichtmaterialien für eine solche Diffusionsbarriere geeignet sind. Die Auswahl der spezifischen Me-Si Verbindungen muss anhand der spezifischen Substratmaterialien und Einsatzbedingungen erfolgen und hängt beispielsweise von der Einsatztemperatur und der Wahl der Oxidationsbarriere ab, die wiederum von den Korrosionsbedingungen im Einsatzgebiet abhängt. Als wichtige Eigenschaft der Me-Si muss hier noch die Korrosionsbeständigkeit erwähnt werden. Es wurden Me-Si Schichten auf niedrig legiertem Stahl im Salzsprühtest nach ASTM B117 Norm untersucht. Es zeigte sich, dass diese Schichten für mehr als 1000 h stabil waren und keine Korrosion auftrat.

In Tabelle 1 sind viele dieser Me-Si Verbindungen angegeben. Erfindungsgemäss bilden diese eine gute Diffusionsbarriere zum Ti-Al Material und erlauben eine weitere Beschichtung mit einer Oxidationsbarriereschicht, um eine Umweltbarriereschicht nach Abbildung 1 zu realisieren. In Tabelle 2 sind einige PVD Oxidschichten, die sich besonders in Kombination mit den erwähnten Me-Si Verbindungen als Oxidationsbarriereschicht eignen, aufgeführt. Alle umfassen, neben dem O auch noch Al als ein wesentliches Element. Zusätzlich sind in Tabelle 3 die bevorzugten Schichtmaterialien für thermische Barriereschichten aufgeführt. Diese umfassen Oxidschichtmaterialien mit einer Wärmeleitfähigkeit kleiner 5 W/(m×K), bestehen aus Al-, Y-und Zr-basierenden Oxiden und können durch Aenderung der Beschichtungsparameter sowohl als dichte Schicht wie auch als poröse Schicht mit säulenförmiger Struktur hergestellt werden.

In Abbildung 3 ist die Kombination der Umweltbarriereschicht aus Abbildung 1 mit einer wesentlich dickeren Oxidationsbarriereschicht dargestellt. In diesem Schichtsystem übernimmt die Oxidationsbarriereschicht, neben ihrer eigentlichen Funktion, zusätzlich durch ihre grössere Dicke auch noch die Funktion der thermischen Barriereschicht. Ueber diese dickere Oxidschicht wird ein Temperaturabfall erreicht, der die thermische Belastung des Ti-Al Materials reduziert und dieses dadurch für höhere Einsatztemperaturen geeignet macht. Prinzipiell kann für diese thermische Barriereschicht die Oxidationsbarrierschicht als Ausgangsmaterial benutzt werden und in diesem Materialsystem weiter beschichtet werden, wobei durch eine Modifizierung der Beschichtungsparameter (beispielsweise durch Erhöhung des Sauerstoffflusses) eine grössere Porosität in die Schicht eingebracht wird, um die Wärmeleitfähigkeit zu reduzieren. Das ist ein bevorzugter Ansatz, weil er einfacher und wirtschaftlicher ist als die in Abbildung 2 dargestellte Möglichkeit der Beschichtung der Oxidationsbarriereschicht mit einem Material, das von dem der Oxidationsbarriere verschieden ist, also beispielsweise ein Zr-Oxid-basierendes Material, das Yttria stabilisiert ist.

### Beschreibung des Tests

Die Tests, die hier beispielhaft an den erfindungsgemässen Schichten durchgeführt wurden, erfolgten bei 800°C in Umgebungsatmosphäre, jeweils für 20 h bzw.100 h. Als Demonstrationssubstrate für die Ergebnisse, die hier gezeigt werden und die nicht als Einschränkung gedacht sind, wurde Ti50Al50 Gussmaterial verwendet. Diese Materialien enthielten keine Dotierungen, um sie sensitiver für Diffusionsvorgänge zu machen.

Ein wesentliches Merkmal für ein wirksames Umweltbarriereschichtsystem ist die Verhinderung einer Ti-Diffusion an die Oberfläche des Schichtsystems nach dem Ausheizprozess an Atmosphäre mit gleichzeitigem Nachweis guter Haftung zwischen Schichtsystem und Substrat.

### Tabellen

**Tabelle 1:**

| Erfindungsgemässe Beschichtung der Diffusionsbarriere nach Abbildung 1 | | | |
|---|---|---|---|
| Schichtfolge: | | | |
| (...) optionale Schichten | | | |
| Metallische Haftschicht | Gradientenschicht | Me-Si Schicht | Uebergang Oxidationsbarriere |
| (Cr, Ni, Ti, Al, Nb, Zr) | (Mo / Mo-Si) | Mo-Si | (Si-O) |
| (Cr, Ni, Ti, Al, Nb, Zr) | (Ti / Ti-Si) | Ti-Si | (Si-O) |
| (Cr, Al) | (Cr / Cr-Si) | Cr-Si | (Si-O, Cr-O) |
| (Cr, Ni, Ti, Al) | (Ni / Ni-Si) | Ni-Si | (Si-O) |
| (Cr, Ti, Al) | (Al / Al- Si) | Al-Si | (Si-O, Al-O) |
| (Cr, Ti, Al, Zr) | (Zr / Zr-Si) | Zr-Si | (Si-O, Zr-O) |
| (Cr, Al, Nb) | (Nb / Nb-Si) | Nb-Si | (Si-O, Nb-O) |
| (Cr, Ti, Al, Hf) | (Hf / Hf-Si) | Hf-Si | (Si-O, Hf-O) |
| (Cr, Al, Zr) | (Al-Zr-Y / Y-Si) | Y-Si | (Si-O, Y-O) |
| (Cr, Ti, Al, Ta) | (Ta / Ta-Si) | Ta-Si | (Si-O, Ta-O) |
| (Cr, Ti, Al, W) | (W / W-Si) | W-Si | (Si-O) |

**Tabelle 2:**

| Erfindungsgemässe Oxidationsbarriereschichten für die verschiedenen Me-Si Diffusionsbarriereschichten nach Abbildung 1 | | |
|---|---|---|
| Me-Si Schicht | Uebergang Oxidationsbarriere | Oxidationsbarriereschichten |
| | optionale Schichten | Komma ist als «und/oder» zu verstehen |
| Mo-Si | (Si-O) | Si-O, Al-O, Al-Cr-O, Cr-O |
| Ti-Si | (Si-O) | Si-O, Al-O, Al-Cr-O, Cr-O |
| Cr-Si | (Si-O, Cr-O) | Si-O, Al-O, Al-Cr-O, Cr-O |
| Ni-Si | (Si-O) | Si-O, Al-O, Al-Cr-O, Cr-O |
| Al-Si | (Si-O, Al-O) | Al-O, Al-Cr-O |
| Zr-Si | (Si-O, Zr-O) | Si-O, Al-O, Al-Cr-O |
| Nb-Si | (Si-O, Nb-O) | Si-O, Al-O, Al-Cr-O |
| Hf-Si | (Si-O, Hf-O) | Si-O, Al-O, Al-Cr-O, Hf-O, Al-Hf-O |
| Y-Si | (Si-O, Y-O) | Al-O, Al-Cr-O, Al-Y-O, Y-O |
| Ta-Si | (Si-O, Ta-O) | Al-O, Al-Cr-O, Al-Ta-O, Ta-O |
| W-Si | (Si-O) | Si-O, Al-O, Al-Cr-O |

**Tabelle 3:**

| Erfindungsgemässe thermische Barriereschichten für die verschiedenen Oxidationsbarriereschichten | | |
|---|---|---|
| Me-Si Schicht | Oxidationsbarriereschichten | Thermische Barriereschicht |
| | Komma ist als "und/oder» zu verstehen | Komma ist als "und/oder» zu verstehen |
| Mo-Si | Si-O, Al-O, Al-Cr-O, Cr-O | Al-Cr-O, YSZ |
| Ti-Si | Si-O, Al-O, Al-Cr-O, Cr-O | Al-Cr-O, YSZ |
| Cr-Si | Si-O, Al-O, Al-Cr-O, Cr-O | Al-Cr-O, YSZ |
| Ni-Si | Si-O, Al-O, Al-Cr-O, Cr-O | Al-Cr-O, YSZ |
| Al-Si | Al-O, Al-Cr-O | Al-Cr-O, YSZ |
| Zr-Si | Si-O, Al-O, Al-Cr-O | Al-Cr-O, YSZ |
| Nb-Si | Si-O, Al-O, Al-Cr-O | Al-Cr-O, YSZ |
| Hf-Si | Si-O, Al-O, Al-Cr-O, Hf-O, Al-Hf-O | Al-Cr-O, YSZ, Hf-O, Al-Hf-O |
| Y-Si | Al-O, Al-Cr-O, Al-Y-O, Y-O | Al-Cr-O, YSZ |
| Ta-Si | Al-O, Al-Cr-O, Al-Ta-O, Ta-O | Al-Cr-O, YSZ |
| W-Si | Si-O, Al-O, Al-Cr-O | Al-Cr-O, YSZ |

Es wurde eine Oberflächenbeschichtung zum Schutz von Substraten mit Ti-Al Material offenbart, wobei die Beschichtung eine Schichtfolge mit mindestens einer Schicht umfasst, vorzugsweise entsprechend einer oder mehrerer der in Tabelle 2 in Zeilen angegebenen Schichtfolgen und wobei die Beschichtung eine auf die Diffusionsbarriere abgestimmte Oxidationsbarriere umfasst die vorzugsweise entsprechend Tabelle 3 abgestimmt ist, wobei die Oberflächenbeschichtung eine thermische Barriere umfasst die vorzugsweise entsprechend Tabelle 4 auf die Oxidationsbarriere abgestimmt ist.

Es wurde ein Verfahren zur Herstellung einer Oberflächenbeschichtung offenbart, wobei die Beschichtung mittels der PVD Methode und mittels der CVD Methode aufgebracht wird und die Beschichtung vorzugsweise in lediglich einem Beschichtungssystem durchgeführt wird.

## Patentansprüche

1. Oberflächenbeschichtung zum Schutz von Substraten mit Ti-Al Material vorzugsweise umfassend eines oder mehrerer der Materialien aus Tabelle 1 wobei die Beschichtung eine Schichtfolge mit mindestens einer Schicht umfasst, die für Ti eine Diffusionsbarriere bildet, vorzugsweise entsprechend einer oder mehrerer der in Tabelle 1 in Zeilen angegebenen Schichtfolgen und wobei die Beschichtung eine auf die Diffusionsbarriere abgestimmte Oxidationsbarriere umfasst die vorzugsweise entsprechend Tabelle 2 abgestimmt ist, wobei die Oberflächenbeschichtung eine thermische Barriere umfasst die vorzugsweise entsprechend Tabelle 3 auf die Oxidationsbarriere abgestimmt ist.

2. Verfahren zur Herstellung einer Oberflächenbeschichtung entsprechend Anspruch 1, **dadurch gekennzeichnet, dass** die Beschichtung mittels der PVD Methode und mittels der CVD Methode aufgebracht wird und die Beschichtung vorzugsweise in lediglich einem Beschichtungssystem durchgeführt wird.
